# EUROPEAN PATENT SPECIFICATION

(11) **EP 1 064 653 B1**
(45) Date of publication and mention of the grant of the patent: **25.09.2002**
(21) Application number: 99911928.2
(22) Date of filing: 23.03.1999
(51) Int. Cl.: G11C 13/04, G11B 7/00

(54) **OPTICAL DATA STORAGE**
OPTISCHER DATENSPEICHER
STOCKAGE DE DONNEES OPTIQUES

(30) Priority: 23.03.1998 GB 9806209
(43) Date of publication of application: 03.01.2001
(73) Proprietor: Hyrcynian Holdings Limited, 3030 Limassol (CY)
(72) Inventor: BURROUGHS, Trevor, London W10 6JL (GB)
(74) Representative: Suèr, Steven Johannes
(86) International application number: GB9900908
(87) International publication number: WO99049469

(56) References cited:
- WO-A-97/24645
- US-A- 4 779 235
- US-A- 5 268 862
- US-A- 5 325 324
- US-A- 5 472 759

## Description

This invention relates to optical storage devices, and it relates especially to such devices as contain a plurality of data storage layers.

Optical data storage is accepted as providing the capability for economical storage of large amounts of digital data and permitting the rapid and accurate retrieval of such data. The compact disc (CD), for example, and derivatives thereof provide ample evidence of these capabilities.

Whilst the CD and other generally planar optical storage devices can store very considerable amounts of data, they generally effect storage of data in only two dimensions, and thus there are definable limits to their storage capacity. Because of this, various attempts have been made to create three dimensional stores, based on the use of layered media, but such arrangements as have been proposed hitherto suffer from various drawbacks, such as the need for high optical intensities to penetrate the plurality of layers and the generation of unwanted crosstalk between the information as retrieved from one layer and that recorded in other, particularly neighbouring, layers. There is also frequently the need for complex optical and/or electronic switching and modulation or discriminatory electronics of high complexity in order to disentangle, upon retrieval, data stored in one layer from those stored in adjacent layers.

Further, where the optical storage device is discoidal in nature, and is intended to be rotatably driven past a reading head, there is a rotational time lag as the device is brought up to speed and the head moved to the correct position.

It is an object of this invention to provide a layered optical data storage device in which at least one of the above-mentioned drawbacks is reduced; the device having a plurality of data storage layers arranged in stacked configuration; the data being retrievable by propagating interrogating energy through the stack of layers, and the data stored in one layer being distinguishable from that stored in other layers by means of a layer selection technique.

Devices of the general kind just described are disclosed in US-A-5 268 862 and US-A-4 779 235; the former document disclosing the use of optical means to select the layers. Neither document, however, addresses practical problems associated with spreading and/or unwanted deviation of the interrogating energy as it traverses the stack of layers.

According to the invention there is provided an optical data storage device comprising a plurality of juxtaposed data storage layers, each capable of storing digitised data; means for directing interrogating energy into said device for passage through said layers and for detecting the energy emergent from the device; the device having optical means for selectively rendering the data stored in a chosen layer capable of influencing the said interrogating energy by means of selecting energy applied selectively to said layers, and being characterised in that at least two of said layers have associated therewith means which co-operate to collimate the interrogating energy in its direction of travel.

Typically, though not necessarily, the direction of travel of the interrogating energy is normal to the layers and, in a particularly favoured arrangement, each layer is formed as a laminate of two layers, one of which comprises the data storage layer and the other of which acts as collimating means.

The collimation may be effected by molecular alignment in the direction of travel of the interrogating energy or by suitably orientated glass fibres or other optical ducting components.

Additionally or alternatively the interrogating energy may be collimated by means external to the device, such as an array of microlenses.

Preferably the interrogating energy is light of broad spectrum which may be incident on the device in a flood beam, but which, in accordance with a particularly advantageous feature of the invention considered inventive in itself, is scanned in a predetermined pattern over a top surface of the device by means of an electronic shutter such as a thin film transistor (TFT) array or a liquid crystal spatial light modulator, preferably a ferroelectric liquid crystal device capable of high speed switching.

It is preferred that the data to be stored in each given layer are impressed as minute indentations in a thin layer of plastics material of desired shape and configuration to constitute an element of the device, and that such indentations are produced by techniques similar to those used in the production of CDS. Where the data to be stored comprises binary "0"s and "1"s, it is preferred that indentations are made only at locations intended to store one of the binary values, say "0"s.

Preferably, the indentations are filled with material that is normally substantially transparent to the interrogating energy, and which matches at least approximately the refractive index of the basic layer material, but which is rendered substantially absorbent of said interrogating energy when illuminated with selecting energy of a predetermined wavelength characteristic.

Alternatively, indentations may be made at all storage locations, irrespective of the binary values to be stored, but only those indentations at locations intended to store one of the binary values (say "0"s) are filled with the above-mentioned material. As a further alternative, indentations of respective and different dimensions can be impressed for the two binary data values; in which case the indentations of either or both dimensions can be filled with the aforementioned material. If all indentations are so filled, however, the device must be rendered capable of distinguishing between stored binary values on the basis of the dimensional difference between the respective indentations associated with such values.

Alternatively the data may be recorded as a pattern of stresses associated with a pressing procedure to which a layer is subjected.

Importantly, the layers can be selectively illuminated from one or more of their edges by said selecting energy, to enable the data stored in only the selected layer to modify the interrogating energy on its passage to the detecting means.

Preferably a common source of said selecting energy is provided and an electronically switchable shutter of any of the kinds referred to above is interposed between the common source and the device to permit the selective impingement of said selecting energy upon the edges of individual layers of the device.

The selecting energy may comprise substantially monochromatic light, or light of a prescribed range, or combination, of wavelengths, capable of transmitting across a selected layer, generally transverse to the direction of passage through the device of the interrogating energy, and capable of interacting with the material filling said indentations to render said material substantially absorbent of the interrogating energy.

Material capable of being so rendered substantially absorbent or otherwise caused to exert a characteristic influence upon the interrogating energy in response to irradiation by the selecting energy will hereinafter be referred to as "optically active material".

If desired, the interrogating energy may be amplitude modulated at a characteristic frequency to render its detection and its differentiation from extraneous energy simpler and/or more efficient. Likewise, the selecting energy may be modulated if desired, and if both the interrogating energy and the selecting energy are modulated, there may or may not be a harmonic or any other form of synchronous relationship between the two modulations.

If the interrogating energy is modulated, this may conveniently be achieved by means of a suitable modulating signal applied to an electronic shutter.

According to the invention from another aspect there is provided an optical data storage device comprising a plurality of juxtaposed data storage layers, each capable of storing digitised data; means for directing interrogating energy into said device for passage through said layers and for detecting the energy emergent from the device, characterised by optical means for selectively rendering the data stored in a chosen layer capable of influencing the said interrogating energy by means of selecting energy applied selectively to said layers, and further characterised by means for scanning the interrogating energy in a predetermined pattern over a top surface of the device by means of an electronic shutter such as a thin film transistor (TFT) array or a liquid crystal spatial light modulator, preferably a ferroelectric liquid crystal device capable of high speed switching.

In order that the invention may be clearly understood and readily carried into effect, one embodiment thereof will now be described with reference to the accompanying drawings, of which:
Figure 1 shows, in schematic form and perspective view, a data storage component of a device according to one example of the invention, and
Figure 2 shows, again in schematic form and perspective view, the component of Figure 1 together with other components of the device.

None of the drawings is to scale in any dimension.

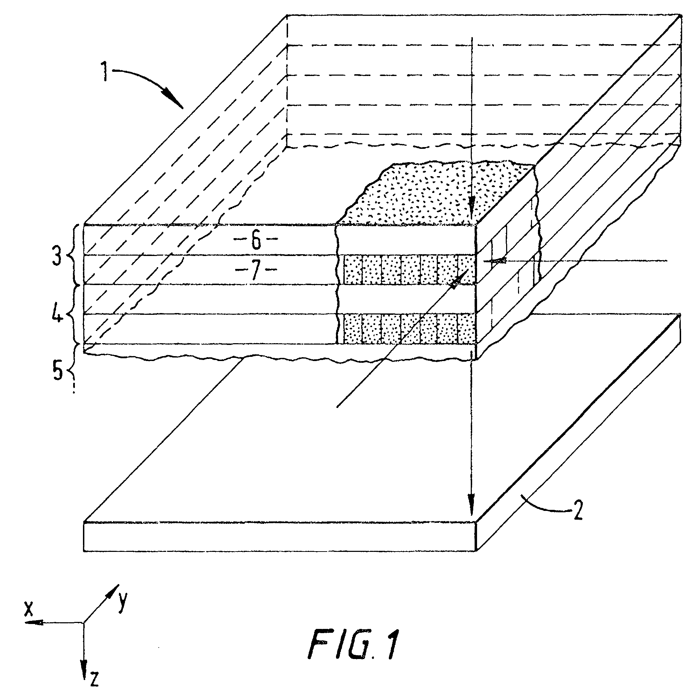

Referring now to Figure 1, the component of a data storage device shown therein comprises principally a data storage body 1 which co-operates with a detector arrangement 2. The body 1 includes several individual and independent storage layers such as 3, 4 and 5. In this example, each storage layer is in the form of a laminate consisting of an upper part such as 6 and a lower part such as 7; both parts being formed of a suitable optical medium such as polycarbonate, and the two parts being bonded together to form a whole.

Data to be stored in the device are recorded, prior to lamination of the layers, in the lower parts such as 7 of each storage layer, for example by pressing indentations into the surface thereof in the same way as compact discs are pressed, at each location where it is desired to store a binary zero and an optically active material, such as silicone mixed with a slightly opaque coloured dye, is applied to the indented surface so as to enter each of the indentations for a reason that will become clear hereinafter, care being taken to ensure that significant quantities of the optically active material are not deposited, or at least are not left, in areas other than the indentations. The upper part such as 6 is then laminated to the lower part and secured thereto in a manner permitting good optical transmission in a direction substantially normal to the layers. In this example, no pits are formed at locations where it is desired to store binary "1"s.

The principal tasks of the material of the upper parts such as 6 of each layer are to collimate light passing therethrough in a direction substantially normal to the layer and to pass such light without substantial attenuation. To these ends, the upper parts 6 are formed of highly transmissive material such as polycarbonate, acetate or glass, and are either processed or fabricated so as to align the molecules of the material in a direction normal to the layers or are constructed of optical fibres or other optical ducting components orientated to achieve the desired effect. Alternatively or additionally, one or more arrays of microlenses, may be used to assist in such collimation.

The lower parts such as 7 of each layer are at least notionally delineated into resolvable elements, or pixels, each of which can be caused, in this example, to assume an optical condition indicative of either a digital "0" or a "1", depending upon the condition impressed upon its surface (i.e. pit and no pit, respectively) and therefore, and importantly, upon the presence or absence of the optically active material. Typically, a data "0" is indicated by a pit impressed into the surface of part 7 (and thus by the presence of the optically active material in the pit). The upper parts such as 6, of course, can be (and preferably are) uniformly constructed over their entire extent.

In the drawings, the plane of each layer such as 3 extends in an x, y co-ordinate plane and the aforementioned direction normal to the layers thus extends in the z-direction. This convention will be adhered to for the remainder of this specification. It will thus be appreciated that light incident upon the component 1 generally in the z-direction will be constrained to pass therethrough, without significant lateral spreading in the x,y plane, by means of the operation of the upper parts such as 6, but that the amount of light emergent from the component in that direction and incident on detector 2 may be influenced from pixel to pixel in the x, y plane of any layer by the information impressed on the lower part 7 of that layer. However, if this principle were adopted simpliciter, the use of multiple layers would be precluded, since the patterns of data recorded in overlying layers would interfere.

In accordance with the invention therefore, the pattern of data recorded in any given layer is rendered capable of influencing so-called interrogating light, travelling in the z-direction, only when that layer is illuminated with light of a particular wavelength, range of wavelengths or combination of wavelengths. In this example, this is achieved by selectively illuminating the layers from one or more directions with so-called selecting energy consisting of light of appropriate characteristics to cause the optically active material deposited in the data pits of the lower part 7 of the layer to temporarily assume a condition that will block the interrogating light.

Thus, pixels where there are no pits are always transmissive of the interrogating light and pixels having pits filled with optically active material are also transmissive to that light unless the optically active material is illuminated by the aforementioned selecting energy. By this means, any individual layer, or portion of a layer, depending on the nature and configuration of the selecting energy, can be caused to influence the interrogating light, in accordance with the pattern of recorded data which it carries, whilst the remainder of the component merely acts as a fairly uniform transmitter of the interrogating light.

In the arrangement shown in the drawings, the data-storing layers are substantially square or rectangular in profile in the x-y plane. This need not necessarily be the case, however, and any convenient profile (which need not in all circumstances remain the same from layer to layer) can be used.

One factor that can influence the choice of the geometric profile of the layers in the x-y plane is the nature and form of the selecting energy needed to temporarily render the optically active material in the data pits of the lower parts 7 of the layers opaque to, or at least highly absorbent of, the interrogating radiation. Another such factor is the arrangement by means of which the selecting energy is caused to impinge on the layers, and this in turn is influenced (among other things) by the degree of flexibility with which it is desired to select between layers and parts of layers.

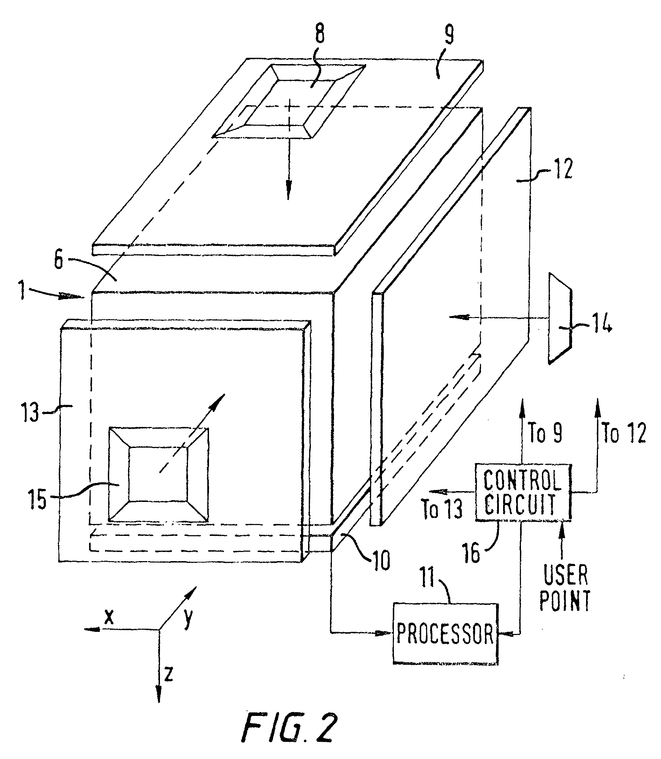

Figure 2 illustrates in broad principle the application of interrogating radiation and selecting energy to the component 1, and the detection of interrogating radiation emergent from the component.

A light source 8, which may produce white light or light of a selected spectral characteristic, generates light which irradiates an electronically controllable shutter 9. The shutter 9 comprises, in this example, a thin-film transistor (TFT) screen parallel to and aligned with the layers of the component 1 and conveniently disposed in contact with, or closely proximate to, the upper part 6 of layer 3.

The arrangement is such that there is a one-to-one relationship between the apertures which can be selectively opened in the shutter 8 and the pixels in the lower part 7 of each layer of component 1; the layers in this example having identical pixel formats and corresponding pixels in different layers being accurately registered and juxtaposed. Thus, the opening of a single aperture in the shutter 9 permits light from the source 8 to enter the component 1 at the appropriate position in the x-y plane and to travel in the z-direction through corresponding pixels in each of the layers 3, 4, 5. Light emergent from the last layer of component 1 (i.e. the layer farthest, in the z-direction, from the shutter 9) is incident on a light detector 10 which may or may not be sensitive to the x-y position at which light is incident thereon but which in any event can provide an electrical output signal, indicative of the amounts of light incident from time to time thereon, to a processor 11 which is also supplied with timing information indicative (inter alia) of the timing of the electronic control signals applied to the shutter 9 and thus effectively of the addresses of the pixels of the layers in component 1 through which light detected at any time by the detector 10 has passed.

By the foregoing means it will be appreciated that the light from source 8 can effectively be scanned in the x-y dimension over the surface of the top layer 3 of component 1, thereby to project the light in sequence, in the z-direction, through corresponding pixels of the layers of component 1 and on to the detector 10.

In the absence of the application of the aforementioned selecting energy to the component 1, the light incident upon detector 10 during a complete cycle of operation of the shutter 9 should be substantially constant, despite variations that will inevitably occur in the combinations of data recorded in corresponding (juxtaposed) pixels of the layers of component 1 from place to place, as the optically active material in the data pits has not been rendered capable of influencing the light from source 8. In practice, however, it is likely that slight variations may occur, and it may be useful in such circumstances to conduct a calibratory scan cycle, during which the signals generated by the detector 10 are recorded by the processor 11 and used, in known manner, to adjust signals generated during normal operation of the device in a sense allowing for such variations.

The shutter 9 and/or an additional, directly associated component (not shown) may if desired be caused to contribute to (or wholly impose) a predetermined spectral characteristic on the light from source 8. For example, the material of the TFT shutter itself may colour the light from source 8 and/or one or more associated filter layers may be provided between the source 8 and the shutter 9 and/or between the shutter 9 and the top layer 3 of component 1. In a further alternative construction, a phosphor layer is deposited on the shutter 9; the phosphor being chosen to generate light of a particular spectral composition. In any event, if the light from source 8 has a particular spectral characteristic imposed thereon, the detector 10 is preferably rendered selectively responsive to light of that characteristic.

Instead of or in addition to the imposition of spectral characteristics as described above, the light from source 8 may be amplitude modulated at a characteristic frequency, to which the detector 10 and/or the processor 11 is sensitive. Such modulation may be imposed upon the source 8 itself and/or upon the shutter 9.

All of the foregoing expedients have the objective of enabling the interrogating radiation transmitted through the component 1 in the z-direction to be readily distinguished from ambient light or that generated by other sources, and accordingly any procedure known to those skilled in the art as being suitable for such purposes may be adopted without departing from the scope of the invention.

It is generally intended that the electronic control of the shutter 9 will be such as to cause the light from source 8 to scan in a regular raster format, one pixel at a time, over the component 1. This need not necessarily be the case however and the scanning may take any convenient form. In particular, there may be advantage in employing a pseudorandom scanning regime in the event that any particular construction, and/or any particular combination of recorded data, gives rise to a tendency for cross-talk to occur between positionally adjacent light paths. Provided that the actual scanning regime is communicated to the processor 11, the necessary correlation between the signals output from detector 10 and the z-direction paths through component 1 to which they relate is retained.

Thus far, then, the arrangement is such as to scan light from source 8 over the component 1 so as to pass in sequence, in the z-direction, along paths through respective groups of overlying pixels of the various layers of component 1, and the light emergent from the component 1 along each of the paths is detected by detector 10. Electrical signals corresponding to the detected light for each path are applied to the processor 11, typically a microprocessor.

In order to influence the optically active material deposited in the data pits associated with binary "0"s, the individual layers are, in this example, irradiated in turn by the selecting energy which, again in this example, is constituted by a combination of light of two different colours incident on the selected layer via respective electronically controlled shutters 12 and 13. The rectangular configuration of the layers renders it convenient to have one of the shutters (12) interact with light from a source 14, incident from the x-direction towards the component 1 and the other shutter (13) interact with light from a source 15 incident from the y-direction towards the component 1.

All of the comments made above in relation to the imposition of spectral characteristics and/or modulation on the light produced by source 8 apply, mutatis mutandis, to the sources 14 and 15, though it will be appreciated that with regard to spectral composition, light from all three sources as incident on the component 1 will be different, and that any modulation applied to the light from sources 14 and 15 will differ from that applied to the light from source 8 and may differ from each other. In any event, the detector 10 and/or the processor 11 will ideally be de-sensitised to light bearing the spectral characteristic and/or modulation applied to the light from sources 14 and 15.

The combination of light incident in the x-y plane on the edge of a selected layer of the component 1 via the shutters 12 and 13 respectively is such as to cause the optically active material in the data pits of the selected layer to temporarily become absorbent and/or reflective of the interrogating radiation from source 8, incident on the component 1 via shutter 9. Thus, for example, if the shutters 12 and 13 are such as to permit light from the sources 14 and 15 respectively to irradiate the entire extent of the selected layer in their dimension, the optically active material in all of the data pits in that layer will be rendered absorbent and/or reflective of the interrogating radiation from source 8. During a complete cycle of operation of the shutter 9, therefore, scanning the interrogating radiation over the component 1 as described previously, the data stored in the selected layer of component 1 will be read out, detected by detector 10 and recorded with appropriate timing for identification in processor 11.

It will be appreciated that the scanning effected by the combined operations of shutters 9, 12 and 13 can be carried out in any convenient manner. For example, the operations of shutters 12 and 13 may be such that either or both of them operates pixel sequentially rather than at full layer width, and the operation of shutter 9 can be changed concomitantly in the event that greater selectivity is effected by shutters 12 and 13. In some configurations, it may be advantageous to operate all three shutters on a pixel-sequential basis in order to achieve highly accurate read-out. In some situations it is desirable to control the shutter operations so that information can be simultaneously read out from more than one z-direction path through the component 1, and such information may be derived from different levels of the component provided that the shutter configurations permit sufficient selectivity for that purpose.

It is important that the selecting energy from sources 14 and 15 be constrained so far as possible to remain within the selected layer (or layers) and to that end the lower parts 7 (see Figure 1) of each layer are preferably configured or constructed so as to promote the passage of light in the x-y plane and resist spreading in the z-direction. This can be achieved, for example, by forming the parts 7 with their molecules preferentially lying in the x-y plane. Techniques known to promote total internal reflection can also be used, provided that they do not unduly interfere with the passage in the z-direction of the interrogating radiation from the source 8 to the detector 10.

In the event that the selecting energy becomes absorbed or scattered to an unacceptable extent in traversing any given layer (for example as a result of the layer containing an unusually large number of data "0" pits) additional radiation can be supplied from the opposing side of the layer, using an identical source and shutter combination duly synchronised in operation to the original. The need for such action may be identified by performing a calibratory scan to read out the data from each layer of the component 1. The processor can be programmed with acceptability thresholds for data readout and to raise a warning flag if, for any reason, these thresholds are not met during the calibration.

Various alternative configurations, constructions, components and materials may be used without departing from the scope of this invention. In particular, but without limitation, the TFT shutters (or any of them) may be replaced by liquid crystal shutters. Ferroelectric liquid crystal devices are particularly advantageous for use in this context because of their high speed switching capabilities.

In one specific example of the operation of a device in accordance with the invention, and assuming the various levels of component 1 to be already recorded with respective data patterns, the selecting energy incident on the edge of a chosen layer via shutter 12 is red, and that incident on the edge of the same layer via shutter 13 is blue. The optically active material in the data pits representing digital "0"s is made (for example by selection of an appropriately coloured dye) such that it absorbs green light and thus, when simultaneously illuminated by the red and blue lights comprising the selecting energy, the material turns black. In areas of the layer other than the "0" data pits, there is no optically active material, and those areas of the layer thus appear green because of the presence of the selecting energy.

Provided that the interrogating radiation comprising the light incident on component 1 in the z-direction via the shutter 9 is capable of interacting differently with the green and black areas, the data stored in the layer can be read out, as already described. In particular, interrogating light is chosen that continues unimpeded by the green areas but is substantially absorbed by the black areas; thus the detector 10 receives a light input if a given z-direction path transits a digital "1" in a selected layer, but receives no light input if the path transits a digital "0" in that layer.

As mentioned previously, the detector 10 provides electrical output signals indicative of the receipt or otherwise of light along various z-direction paths to the processor 11 which is supplied with information as to the electronic operation of the shutters from a control circuit 16 which generates, under user input, the operating control signals for the various shutters, and can thus identify the paths to which individual electrical signals from the detector 10 relate.

Clearly, data from other layers of the component 1 are read by applying the selecting energy to those layers in turn.

As mentioned previously, simultaneous interrogation of regions in different layers of component 1 can be achieved provided that such regions contain no common z-direction paths, and provided of course that the shutters are capable of providing the necessary pattern of combinations of interrogating radiation and selecting energy, and provided that the detector 10 is rendered capable of distinguishing between input light simultaneously received via different z-direction paths. This can readily be achieved by utilising a detector array, rather than a common detector, though the potential for differential performance between the various detectors of the array may need to be allowed for by means of calibratory procedures such as those described above. It is also possible to differentiate between information derived simultaneously from different layers if the two layers are respectively irradiated with interrogating energy of differing characteristics (e.g. infra-red and ultra-violet energy respectively); provided that the two different interrogating energies are such as to be influenced, in measurably distinct ways, by the optically active material in the data pits of the two layers, and that the associated detecting circuitry is capable of distinguishing such influence.

If desired, different detectors in the array could be connected to different processors, each associated with a respective device such as a hi-fi, a computer and a video reproducer/recorder.

In an alternative procedure for recording the data in the layers of the component 1, the pits are not filled with optically active material. Instead, advantage is taken of the fact that stresses are induced in the material of a layer by the process of impressing the pits. It is found that the stressed regions associated with the impressed pits exhibit optical variation enabling layer selection to be effected in the manner described above.

In another alternative procedure, pits are produced at each pixel, but only those at which zeros (for example) are required are filled with optically active material. In yet another arrangement, pits of respective and different dimensions can be impressed for the two binary data values; in which case the indentations of either or both dimensions can be filled with the aforementioned material. If all indentations are so filled, however, the device must be rendered capable of distinguishing between stored binary values on the basis of the dimensional difference between the respective indentations associated with such values.

With regard to dimensions, a typical pixel (data pit) is of dimensions 10 microns square. A rectangular array of 10,000 by 8,000 pixels can thus be accommodated in a layer of size 10cm by 8cm in the x-y plane. Each layer is typically 40 microns thick, so that 250 layers occupy a thickness of 10mm. A device with these dimensions has a storage capacity of some 20 Gigabyte in a unit similar in size to a tape cassette which is readable at RAM chip speeds.

Where the optical storage device is discoidal, or substantially discoidal in nature, resembling, for example, a multi-layered CD, it can be convenient to arrange for the selecting energy to be applied selectively to the layers along two pencil-like beams, one of which is static and is directed parallel to the line of travel of a conventionally positioned and scanned laser interrogating beam. The other pencil-like beam is disposed orthogonally to the first and intersects it at all times, but emulates and accurately tracks the motion of the laser interrogating beam such that the point of intersection of the two pencil-like beams sequentially (and in synchronism with the laser interrogating beam) illuminates each individual storage location (pixel) in the selected layer. The fixed pencil-like beam may, if desired, be replaced by a substantially planar flood beam irradiating all or a significant amount of the layer in question. The shape of the outer rim of the device may be made other than a smooth circle, if desired, to mitigate the varying attack angles encountered by the scanned pencil-like beam during its scanning movement, and the differing reflective geometries associated therewith. In one example, the edge of each layer of the device comprises a large number (e.g. one thousand) equal chordal facets.

This provides a discoidal system, with all of the convenience and attributes associated therewith, having a considerably increased storage capability without attendant problems such as inter-layer interference. It is possible to use an optomagnetic recording system or a dye-based optical recording system in accordance with current CD recording and/or rewriting practice.

## Claims

1. An optical data storage device (1) comprising a plurality of juxtaposed data storage layers (3, 4, 5), each capable of storing digitised data; means (8, 9) for directing interrogating energy into said device for passage through said layers and (2, 10) for detecting the energy emergent from the device, the device (1) further comprising optical means (12, 13, 14, 15) for selectively rendering the data stored in a chosen layer capable of influencing the said interrogating energy by means of selecting energy applied selectively to said layers, and the device being **characterised in that** at least two of said layers (3, 4, 5) have associated therewith means (6) which co-operate to collimate the interrogating energy in its direction of travel.

2. A device according to claim 1 **characterised in that** each layer (3, 4, 5) is formed as a laminate of two layers (6, 7), one of which (7) comprises the data storage layer and the other of which (6) acts as collimating means.

3. A device according to claim 1 or claim 2 **characterised in that** the collimation means (6) comprises alignment, in the direction of travel of the interrogating energy, of molecules within said layer.

4. A device according to claim 1 or claim 2 **characterised in that** the collimation means (6) comprises glass fibres orientated in the direction of travel of the interrogating energy.

5. A device according to any preceding claim **characterised in that** said interrogating energy is collimated by means including an array of microlenses.

6. A device according to any preceding claim **characterised in that** the interrogating energy is light of broad spectrum scanned in a predetermined pattern over a top surface of the device by an electronic shutter means (9).

7. A device according to claim 6 **characterised in that** said electronic shutter means (9) comprises a thin film transistor (TFT) array.

8. A device according to claim 6 **characterised in that** said electronic shutter means (9) comprises a liquid crystal spatial light modulator.

9. A device according to claim 8 **characterised in that** said liquid crystal spatial light modulator comprises a ferroelectric liquid crystal device capable of high speed switching.

10. A device according to any preceding claim **characterised in that** the data to be stored in each given layer are impressed as minute indentations in a thin layer (7) of plastics material.

11. A device according to claim 10 **characterised in that** the indentations are filled with material that is normally substantially transparent to the interrogating energy, and which matches at least approximately the refractive index of the material of said layer (7), but which is rendered substantially absorbent of said interrogating energy when illuminated with selecting energy of a predetermined wavelength characteristic.

12. A device according to any preceding claim **characterised in that** means (12, 14; 13,15) are provided to selectively illuminate the layers (3, 4, 5) from one or more of their edges by said selecting energy, to enable the data stored in only selected layers to modify the interrogating energy on its passage to the detecting means.

13. A device according to any preceding claim **characterised in that** a common source (12, 13) of said selecting energy is provided and an electronically switchable shutter means (14, 15) is interposed between the common source and the device (1) to permit the selective impingement of said selecting energy upon the edges of individual layers of the device.

14. A device according to any of claims 11 to 13, **characterised in that** said selecting energy comprises substantially monochromatic light, or light of a prescribed range, or combination, of wavelengths, capable of transmitting across a selected layer, generally transverse to the direction of passage through the device of the interrogating energy, and capable of interacting with the material filling said indentations to render said material substantially absorbent of the interrogating energy.

15. A device according to any preceding claim **characterised by** the provision of means for modulating the amplitude of the interrogating energy at a characteristic frequency.

16. A device according to any preceding claim **characterised by** the provision of means for modulating the amplitude of the selecting energy at a characteristic frequency.

17. An optical storage device according to claim 15 and claim 16, **characterised by** the provision of a predetermined relationship between the respective characteristic frequencies at which said interrogating energy and said selecting energy are modulated.

## Patentansprüche

1. Optische Datenspeichervorrichtung (1), welche eine Mehrzahl von übereinanderllegenden Datenspelcherschlchten (3, 4, 5) aufweist, welche jeweils digitalisierte Daten speichern können; und eine Einrichtung (8, 9) zum Einleiten einer Abfrageenergie in die Vorrichtung zum Durchgang durch die Schichten und (2, 10) zum Detektieren der aus der Vorrichtung austretenden Energie aufweist, wobei die Vorrichtung (1) ferner eine optische Einrichtung (12, 13, 14, 15) aufweist, welche selektiv die in einer gewählten Schicht gespelcherten Daten unter Wechselwirkung mit der Abfrageenergie durch Anlegen einer Wählenergie aktiviert, die selektiv an die Schichten angelegt wird, und sich die Vorrichtung dadurch auszeichnet, dass wenigstens zwei der Schichten (3, 4, 5) zugeordnete Einrichtungen (6) enthalten, welche derart zusammenarbeiten, dass die Abfrageenergle in Bewegungsrichtung kollimiert wird.

2. Vorrichtung nach Anspruch 1, **dadurch gekennzeichnet, dass** jede Schicht (3, 4, 5) in Form eines Laminats aus zwei Schichten (6, 7) ausgebildet ist, von denen eine (7) die Datenspeicherschicht aufweist und die andere (6) als Kollimationseinrichtung wirkt.

3. Vorrichtung nach Anspruch 1 oder 2, **dadurch gekennzeichnet, dass** die Kollimationseinrichtung (6) in Bewegungsrichtung der Abfrageenergie Moleküle in der Schicht ausrichtet.

4. Vorrichtung nach Anspruch 1 oder Anspruch 2, **dadurch gekennzeichnet, dass** die Kollimationseinrichtung (8) Glasfasern aufweist, weiche in Bewegungsrichtung der Abfrageenergie orientiert sind.

5. Vorrichtung nach einem der vorangehenden Ansprüche, **dadurch gekennzeichnet, dass** die Abfrageenergie mit Hilfe einer Gruppe von Mikrolinsen kollimiert wird.

6. Vorrichtung nach einem der vorangehenden Ansprüche, **dadurch gekennzeichnet, dass** die Abfrageenergie Licht mit einem breiten Spektrum ist, welches mit einem vorgegebenen Muster über einer Oberfläche der Vorrichtung mittels einer elektronischen Verschlusseinrichtung (9) abgetastet wird.

7. Vorrichtung nach Anspruch 6, **dadurch gekennzeichnet, dass** die elektronischen Verschlusseinrichtung (9) eine Dünnfilmtransistor (TFT)-Anordnung aufweist.

8. Vorrichtung nach Anspruch 6, **dadurch gekennzeichnet, dass** die elektronischen Verschlusseinrichtung (9) einen räumlichen Lichtmodulator auf Flüssigkristallbasis aufweist.

9. Vorrichtung nach Anspruch 8, **dadurch gekennzeichnet, dass** der räumliche Lichtmodulator auf Flüssigkristallbasis eine ferroelektrische Flüssigkristalleinrichtung aufweist, welche ein Hochgeschwindigkeitsschalten gestattet.

10. Vorrichtung nach einem der vorangehenden Ansprüche, **dadurch gekennzeichnet, dass** die in der jeweiligen Schicht zu speichernden Daten als winzige Vertiefungen In eine dünne Schicht (7) aus Kunststoffmaterial eingeprägt wird.

11. Vorrichtung nach Anspruch 10, **dadurch gekennzeichnet, dass** die Vertiefungen mit Material ausgefüllt sind, welches im Grundzustand im wesentlichen gegenüber der Abfrageenergie durchlässig ist und welches wenigstens etwa auf den Brechungsindex des Materials der Schicht (7) abgestimmt ist, welches aber im wesentlichen gegenüber der Abfrageenergie absorptionsfähig ist, wenn eine Ausleuchtung mit einer gewählten Energie mit einer vorbestimmten Wellenlängencharakteristik erfolgt.

12. Vorrichtung nach einem der vorangehenden Ansprüche, **dadurch gekennzeichnet, dass** die Einrichtungen (12, 14; 13, 15) vorgesehen sind, um die Schichten (3, 4, 5) von ein oder mehreren Kanten durch die Wählenergie auszuleuchten, um zu ermöglichen, dass die gespeicherten Daten in nur ausgewählten Schichten die Abfrageenergie bei dem Durchgang zu der Dstektionseinrichtung modifizieren.

13. Vorrichtung nach einem der vorangehenden Ansprüche, **dadurch gekennzeichnet, dass** eine gemeinsame Quelle (12, 13) für die Wählenergie vorgesehen ist, und eine elektronisch schaltbare Verschlusseinrlchtung (14, 15) zwischen der gemeinsamen Quelle und der Vorrichtung (1) angeordnet ist, um zu ermöglichen, dass selektiv die Wählenergie auf die Kanten der einzelnen Schichten der Vorrichtung auftrifft.

14. Vorrichtung nach einem der Ansprüche 11 bis 13, **dadurch gekennzeichnet, dass** die Wählenergie ein im wesentlichen monochromatisches Licht oder Licht in einem vorbestimmten Bereich oder eine Kombination aus Wellenlängen aufweist, welche eine Übertragung über eine gewählte Schicht im allgemeinen quer zur Bewegungsrichtung der Abfrageenergie durch die Vorrichtung gestattet und eine Wechselwirkung mit dem die Vertiefungen ausfüllenden Material auftritt, um das Material im wesentlichen für die Abfrageenergie absorptionsfähig zu machen.

15. Vorrichtung nach einem der vorangehenden Ansprüche, **dadurch gekennzeichnet, dass** eine Einrichtung zum Modulieren der Amplitude der Abfrageenergie bei einer charakteristischen Frequenz vorgesehen ist.

16. Vorrichtung nach einem der vorangehenden Ansprüche, **dadurch gekennzeichnet, dass** eine Einrichtung zum Modulleren der Amplitude der Wählenergie bei einer charakteristischen Frequenz vorgesehen ist.

17. Optische Speichervorrichtung nach Anspruch 15 und Anspruch 16, **dadurch gekennzeichnet, dass** ein vorbestimmter Zusammenhang zwischen den entsprechenden charakteristlschen Frequenzen vorhanden ist, bei denen die Abfrageenergie und die Wählenergle moduliert werden.

## Revendications

1. Dispositif (1) de stockage de données optiques, comprenant une pluralité de couches de stockage de données juxtaposées (3, 4, 5,), chacune étant capable de stocker des données numérisées ; des moyens (8, 9) pour diriger l'énergie d'interrogation dans ledit dispositif en vue du passage à travers lesdites couches et (2, 10) pour détecter l'énergie émergente du dispositif, le dispositif (1) comprenant en outre des moyens optiques (12, 13, 14, 15) pour rendre sélectivement les données stockées dans une couche choisie capables d'influencer ladite énergie d'interrogation au moyen d'une énergie de sélection appliquée sélectivement auxdites couches, et le dispositif étant **caractérisé par le fait qu'**à au moins deux desdites couches (3, 4, 5) sont associées des moyens (6) qui coopèrent pour collimater l'énergie d'interrogation dans sa direction de déplacement.

2. Dispositif selon la revendication 1, **caractérisé par le fait que** chaque couche (3, 4, 5) est formée en tant que stratifié de deux couches (6, 7), dont l'une (7) comprend la couche de stockage des données et dont l'autre (6) agit en tant que moyen de collimation.

3. Dispositif selon la revendication 1 ou la revendication 2, **caractérisé par le fait que** le moyen de collimation (6) comprend l'alignement, dans la direction de déplacement de l'énergie d'interrogation, de molécules à l'intérieur de ladite couche.

4. Dispositif selon la revendication 1 ou la revendication 2, **caractérisé par le fait que** le moyen de collimation (6) comprend des fibres de verre orientées dans la direction de déplacement de l'énergie d'interrogation.

5. Dispositif selon l'une quelconque des revendications précédentes, **caractérisé par le fait que** ladite énergie d'interrogation est collimatée par des moyens comprenant un réseau de microlentilles.

6. Dispositif selon l'une quelconque des revendications précédentes, **caractérisé par le fait que** l'énergie d'interrogation est la lumière de large spectre balayée dans un motif prédéterminé sur une surface supérieure du dispositif par un moyen d'obturateur électronique (9).

7. Dispositif selon la revendication 6, **caractérisé par le fait que** ledit moyen d'obturateur électronique (9) comprend un réseau de transistors en couche mince (TFT).

8. Dispositif selon la revendication 6, **caractérisé par le fait que** ledit moyen d'obturateur électronique (9) comprend un modulateur spatial de lumière à cristaux liquides.

9. Dispositif selon la revendication 8, **caractérisé par le fait que** ledit modulateur spatial de lumière à cristaux liquides comprend un dispositif à cristaux liquides ferroélectriques capable de commutation à haute vitesse.

10. Dispositif selon l'une quelconque des revendications précédentes, **caractérisé par le fait que** les données devant être stockées dans chaque couche donnée sont imprimées sous la forme de minuscules empreintes dans une couche mince (7) de matière plastique.

11. Dispositif selon la revendication 10, **caractérisé par le fait que** les empreintes sont remplies d'une matière qui est normalement sensiblement transparente à l'énergie d'interrogation, et qui s'adapte au moins approximativement à l'indice de réfraction de la matière de ladite couche (7), mais qui est rendue sensiblement absorbante de ladite énergie d'interrogation lorsqu'elle est éclairée par de l'énergie de sélection d'une caractéristique de longueur d'onde prédéterminée.

12. Dispositif selon l'une quelconque des revendications précédentes, **caractérisé par le fait que** des moyens (12, 14 ; 13, 15) sont prévus pour éclairer sélectivement les couches (3, 4, 5) à partir d'une ou plusieurs de leurs bordures par ladite énergie de sélection, pour permettre aux données stockées dans seulement les couches choisies de modifier l'énergie d'interrogation sur son passage dans les moyens de détection.

13. Dispositif selon l'une quelconque des revendications précédentes, **caractérisé par le fait qu'**une source courante (12, 13) de ladite énergie de sélection est prévue et qu'un moyen d'obturateur commutable électroniquement (14, 15) est interposé entre la source courante et le dispositif (1) pour permettre le choc sélectif de ladite énergie de sélection sur les bordures de couches individuelles du dispositif.

14. Dispositif selon l'une quelconque des revendications 11 à 13, **caractérisé par** le fait ladite énergie de sélection comprend de la lumière sensiblement monochromatique, ou de la lumière d'une plage, ou combinaison, prescrite de longueurs d'onde, capable de transmettre à travers une couche choisie, généralement transversale à la direction de passage à travers le dispositif de l'énergie d'interrogation, et capable d'interagir avec la matière remplissant lesdites empreintes pour rendre ladite matière sensiblement absorbante de l'énergie d'interrogation.

15. Dispositif selon l'une quelconque des revendications précédentes, **caractérisé par** la disposition de moyens pour moduler l'amplitude de l'énergie d'interrogation à une fréquence caractéristique.

16. Dispositif selon l'une quelconque des revendications précédentes, **caractérisé par** la disposition de moyens pour moduler l'amplitude de l'énergie de sélection à une fréquence caractéristique.

17. Dispositif de stockage optique selon la revendication 15 et la revendication 16, **caractérisé par** la disposition d'une relation prédéterminée entre les fréquences caractéristiques respectives auxquelles ladite énergie d'interrogation et ladite énergie de sélection sont modulées:
